# EUROPEAN PATENT APPLICATION

(11) **EP 4 318 663 A1**
(43) Date of publication of application: **07.02.2024**
(21) Application number: 21935216.8
(22) Date of filing: 22.12.2021
(51) Int. Cl.: H01M 4/525, H01M 10/052, H01M 10/0566, H01M 10/0585, H01M 50/202

(54) **CIRCUIT BOARD ASSEMBLY**

(30) Priority: 29.03.2021 JP 2021055845
(71) Applicant: NGK Insulators, Ltd., Nagoya city, Aichi 467-8530 (JP)
(72) Inventor: NAKASHIMA, Eiji, Nagoya-city, Aichi 467-8530 (JP)
(74) Representative: Müller-Boré & Partner Patentanwälte PartG mbB
(86) International application number: PCT/JP2021/047630
(87) International publication number: WO 2022/209067

(57) **Abstract**

Provided is a circuit board assembly that includes a lithium secondary battery, and is compact, excellent in durability, and high in output stability. The circuit board assembly includes a wiring board, the lithium secondary battery electrically connected to the wiring board, and a wireless communication device electrically connected to the wiring board. The lithium secondary battery includes a positive electrode, a negative electrode arranged to face the positive electrode, and an electrolyte. In the lithium secondary battery, an electrode area (S) and a battery resistance (R) satisfy a relationship of 0.08 ≤ R/S ≤ 1.80 (Ω/cm²), where the electrode area is an area where the positive electrode and the negative electrode face each other.

## Description

### Technical Field

The present disclosure relates to a circuit board assembly. The present application claims priority based on Japanese Patent Application No. 2021-55845 filed on March 29, 2021, the entire contents of which are incorporated herein by reference.

### Background Art

A circuit board assembly having a secondary battery and a wireless communication device mounted on a circuit board is known. For example, Patent Literature 1 discloses a circuit board assembly that includes a coin-type lithium secondary battery connected to the board by reflow soldering, and a wireless communication device. The invention in Patent Literature 1 focuses on the problem that when a battery is fixed to a board by reflow soldering, the battery performance is degraded because of being heated to a high temperature. It has then found that adjusting the capacity of the positive electrode and that of the negative electrode can suppress the degradation of battery performance attributable to heating.

### Citation List

### Patent Literature

Patent Literature 1: International Publication No. WO 2020/090803

### Summary of Invention

### Technical Problem

Electronic devices, including IoT devices such as smart cards and wearable terminals, are becoming increasingly diversified and downsized. In accordance with such circumstances, circuit board assemblies incorporated into the devices are also required to be more compact. In addition, the batteries incorporated in circuit board assemblies are desired to be highly reliable, with stable output over a long period of time, even under the conditions of use in which high-current pulse discharges are repeated for wireless communications and the like.

Therefore, one of the objects of the invention according to the present disclosure is to provide a circuit board assembly that is compact, excellent in durability, and high in output stability.

### Solution to Problem

A circuit board assembly according to the present invention includes: a wiring board; a lithium secondary battery electrically connected to the wiring board; and a wireless communication device electrically connected to the wiring board. The lithium secondary battery includes a positive electrode, a negative electrode arranged to face the positive electrode, and an electrolyte. Further, in the lithium secondary battery, an electrode area (S) and a battery resistance (R) satisfy a relationship of 0.08 ≤ R/S (Ω/cm²) ≤ 1.80, where the electrode area is a area where the positive electrode and the negative electrode face each other.

### Advantageous Effects of Invention

The above circuit assembly can provide a circuit board assembly that is compact, excellent in durability, and high in output stability.

### Brief Description of Drawings

FIG. 1 is a schematic side view of a circuit board assembly.
FIG. 2 is a schematic plan view of the circuit board assembly.
FIG. 3 is a schematic plan view showing the structure of a pouch-type lithium secondary battery.
FIG. 4 is a schematic cross-sectional view showing the structure of the pouch-type lithium secondary battery.
FIG. 5 is a graph illustrating a relationship between electrode area (S) and battery resistance (R) of a lithium secondary battery in a circuit board assembly.
FIG. 6 is a diagram illustrating the flow of production of a pouch-type lithium secondary battery.
FIG. 7 is a diagram illustrating an evaluation circuit for a circuit board assembly.

### Description of Embodiments

### [Outline of Embodiments]

First, embodiments of the present disclosure will be listed and described. A circuit board assembly of the present disclosure includes: a wiring board; a lithium secondary battery electrically connected to the wiring board; and a wireless communication device electrically connected to the wiring board. The lithium secondary battery includes a positive electrode, a negative electrode arranged to face the positive electrode, and an electrolyte. Further, in the lithium secondary battery, an electrode area (S) and a battery resistance (R) satisfy a relationship of 0.08 ≤ R/S (Ω/cm²) ≤ 1.80, where the electrode area is an area where the positive electrode and the negative electrode face each other.

As used herein, the electrode area (S) refers to an area (cm²) of a portion in the lithium secondary battery where the positive and negative electrodes are facing each other. Facing each other includes, not only a mode in which the electrodes directly face each other, but also a mode in which the electrodes face each other via a separator or the like (i.e., the separator is present between the positive and negative electrodes). The battery resistance (R) refers to an internal resistance (Ω) of the battery, which is measured using a method described later.

The circuit board assembly of the present disclosure includes the lithium secondary battery, and the ratio (R/S) between the electrode area (S), which is the area where the positive and negative electrodes face each other in the lithium secondary battery, and the battery resistance (R), which is the internal resistance of the battery, is adjusted to fall within a predetermined numerical range. It has been found in the present disclosure that the R/S being in a predetermined range provides two effects of stable pulse output and excellent cycle characteristics of the battery. In the circuit board assembly of the present disclosure, the internal resistance per electrode area (R/S) is 1.80 or less, resulting in stable pulse output and highly stable communication operations. Further, in the circuit board assembly of the present disclosure, the internal resistance per electrode area (R/S) is 0.08 or more. The low resistance provides favorable pulse output performance, high cycle characteristics, and excellent battery durability. It is therefore possible to provide a highly functional and highly reliable circuit board assembly which is suitable for applications of wide variety and wide uses.

In the circuit board assembly described above, the electrode area (S) may be 6 cm² or less. With the electrode area of 6 cm² or less, the size of the entire battery including the exterior body can be made sufficiently small, allowing for suitable use in applications of small sizes.

In the circuit board assembly described above, the lithium secondary battery may further include a separator disposed between the positive electrode and the negative electrode, and may include, as the electrolyte, an electrolytic solution that is impregnated into the positive electrode, the negative electrode, and the separator. With the use of a lithium secondary battery that includes a separator and an electrolytic solution, a highly functional and highly reliable circuit board assembly is obtained using the battery with stable quality and with high output at room temperature.

In the circuit board assembly described above, the positive electrode may include a plate-shaped ceramic sintered body containing a lithium complex oxide, wherein the lithium complex oxide is a complex oxide of lithium and a transition metal element, partially substituted with another metal element that is a substitution metal element. In the case of adopting the above-described plate-shaped ceramic sintered body as the positive electrode, it is possible to stably and reliably obtain a circuit board assembly with the R/S (Ω/cm²) of 0.08 or more and 1.80 or less.

### [Specific Embodiments]

Specific embodiments of the circuit board assembly of the present disclosure will be described below with reference to the drawings. In the drawings referenced below, the same or corresponding portions are denoted by the same reference numerals and the description thereof will not be repeated.

### (Structure of Circuit Board Assembly)

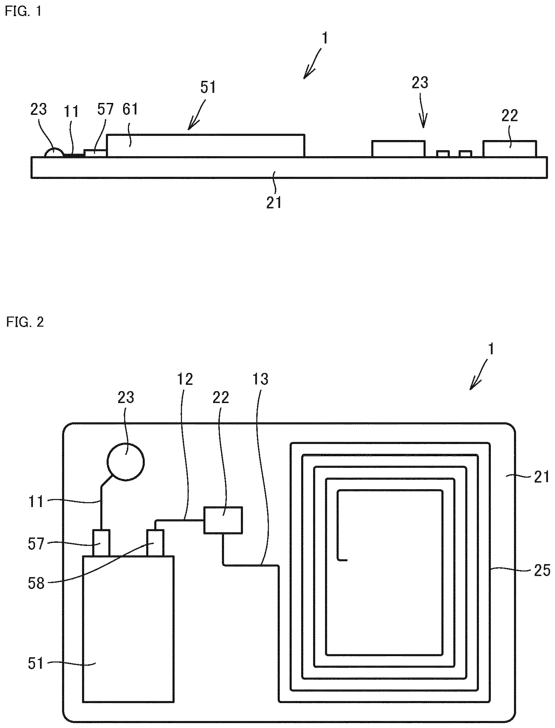

FIG. 1 is a schematic side view showing an embodiment of a circuit board assembly according to the present disclosure. Referring to FIG. 1, the circuit board assembly 1 further includes a battery 51 which is a lithium secondary battery, a wiring board 21, a wireless communication device 22, and another electronic component 23. The wiring board 21 is a so-called printed wiring board and has conductive wiring on its top surface. The wiring may be provided inside or on a bottom surface of the wiring board 21. Although one wiring board 21 is illustrated in FIG. 1, the wiring board 21 may have a structure in which a plurality of partial wiring boards are assembled. Although the battery 51 is described using the pouch-type lithium secondary battery, the battery is not limited thereto. The battery 51 may be a coin-type lithium secondary battery or an all-solid-state lithium secondary battery.

The battery 51 is fixed on the wiring board 21. For example, a part or a whole of one surface of an exterior body 61 of the battery 51 is attached to the wiring board 21 using an adhesive or the like. The battery 51 has a positive electrode tab terminal 57 connected to wiring 11 via, for example, solder or the like. With the positive electrode tab terminal 57 and the wiring 11 connected to each other, the battery 51 is electrically connected to the wiring board 21. Although the thickness of the circuit board assembly 1 is not particularly limited, the circuit board assembly can be of a thin type with a thickness of, for example, 0.5 mm or less, and more preferably 0.3 mm or less.

FIG. 2 is a schematic plan view showing an embodiment of the circuit board assembly according to the present disclosure. Referring to FIG. 2, the circuit board assembly 1 has the battery 51, the wireless communication device 22, the electronic component 23 such as a capacitor, and an antenna 25 electrically connected via printed wiring 11, 12, and 13 on the wiring board 21. The battery 51 is used as a power supply source in the circuit board assembly 1. The size of the wiring board 21 constituting the circuit board assembly 1 is not particularly limited, and it may be a rectangular board made of resin having a side length of about 50 mm to about 80 mm, for example. As an example, the wiring board may be a resin board with dimensions of about 50 mm × about 80 mm.

The wireless communication device 22 may be an electric circuit module including an antenna and a communication circuit. The wireless communication device 22 may have terminals connected to the wiring 12 and 13 of the wiring board 21 via solder or an anisotropic conductive film (ACF). The connection between the terminals of the wireless communication device 22 and the wiring is performed, for example, by soldering with iron soldering. The wireless communication device 22 may be a device that performs communications via radio waves. The wireless communication device 22 may be a device dedicated to transmission, or may be a device capable of transmission and reception.

Examples of the other electronic component 23 included in the circuit board assembly 1 according to the present disclosure include a circuit that generates signals to be transmitted, a circuit that processes received signals, a capacitor, a sensor, various measuring devices, and a terminal that receives signals from the outside.

The circuit board assembly 1 may be incorporated into a variety of IoT devices. As an example, the assembly may be built in a smart card having an arithmetic processing function. The smart card is a flexible card-type device. The smart card is used as, for example, a card with fingerprint authentication and wireless communication functions, being equipped with a wireless communication IC, an ASIC for fingerprint analysis, and a fingerprint sensor.

### (Structure of Battery)

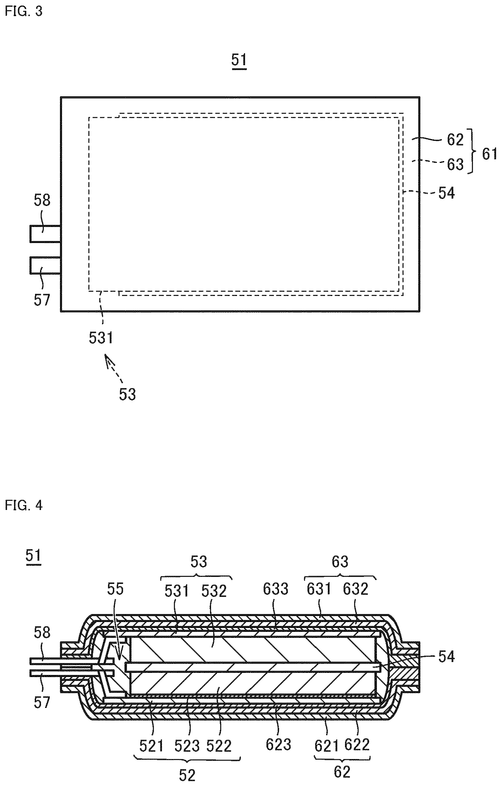

FIGS. 3 and 4 show the battery 51, out of the circuit board assembly 1 according to the present disclosure. FIG. 3 is a schematic plan view showing the configuration of the battery 51. FIG. 4 is a schematic cross-sectional view showing the configuration of the battery 51. In both FIGS. 3 and 4, the actual configuration is partially enlarged, emphasized, or omitted for ease of understanding. In other words, the configuration shown in FIGS. 3 and 4 does not necessarily reflect actual dimensions.

Referring to FIGS. 3 and 4, the battery 51, which is a lithium secondary battery, includes a pair of exterior films 62 and 63 constituting the exterior body 61, a battery body, the positive electrode tab terminal 57, and a negative electrode tab terminal 58. The exterior films 62 and 63 have an identical rectangular shape as viewed in the thickness direction. The exterior films 62 and 63 have four peripheral edges that are bonded together except for the portions facing each other with the positive electrode tab terminal 57 and the negative electrode tab terminal 58 sandwiched therebetween. Specific way of bonding is not particularly limited, and they may be bonded by adhering, fusing, and the like.

The battery 51 is a compact and thin battery. The dimensions of the battery 51 (outer dimensions of the exterior body 61) are not particularly limited, and in plan view, the longitudinal length may be 10 to 46 mm, and the lateral length may be 10 to 46 mm, for example. The thickness of the battery 51 (thickness of the exterior body 61) is for example 0.3 mm to 0.45 mm, and preferably 0.4 mm to 0.45 mm. The battery 51 as a whole is a sheet-shaped or flexible plate-shaped component.

Referring to FIG. 4, an internal space is formed between the opposing inner surfaces of the exterior films 62 and 63. The internal space accommodates the battery body. The battery 51 includes a positive electrode 52, a negative electrode 53, a separator 54, an electrolytic solution 55, the exterior body 61, and the two terminals 57 and 58. In the battery 51, the positive electrode 52, the negative electrode 53, the separator 54, and the electrolytic solution 55 are collectively referred to as the battery body. The positive electrode 52, the negative electrode 53, and the separator 54 are superposed in a predetermined superposition direction. In the example shown in FIG. 4, the positive electrode 52, the separator 54, and the negative electrode 53 are stacked in the up-down direction in the figure. In other words, the positive electrode 52 and the negative electrode 53 face each other with the separator 54 in between. In the following description, the upper side and the lower side in FIG. 4 will be referred to as the "upper side" and the "lower side", respectively, in the battery 51. The up-down direction in FIG. 4 will be referred to as the "up-down direction" or "stacking direction".

The exterior body 61 is a bag body made up of the exterior films 62 and 63 with their peripheral edges bonded together. The exterior films 62 and 63 are each formed by a laminated sheet composed of, for example, a metal foil 621, 631 made of a metal such as aluminum (Al) and an insulating resin layer 622, 632 laminated together. The exterior sheets 62 and 63 are arranged such that the metal foils 621 and 631 are positioned on the outer side of the bag body and the resin layers 622 and 632 are positioned on the inner side of the bag body.

Referring to FIGS. 3 and 4, the exterior body 61 covers the entirety of the battery body. The exterior body 61, which is a bag body, houses the positive electrode 52, the negative electrode 53, the separator 54, and the electrolytic solution 55 therein. The electrolytic solution 55 is present continuously around the positive electrode 52, the separator 54, and the negative electrode 53. In other words, the electrolytic solution 55 exists between the positive electrode 52 and the negative electrode 53. The electrolytic solution 55 is impregnated in the positive electrode 52, the separator 54, and the negative electrode 53. The positive electrode tab terminal 57 and the negative electrode tab terminal 58 extend from the inside to the outside of the exterior body 61. Inside the exterior body 61, the positive electrode tab terminal 57 is connected to a positive electrode current collector 521. With this configuration, the positive electrode tab terminal 57 is electrically connected to the positive electrode 52. The negative electrode tab terminal 58 is connected to a negative electrode current collector 531. With this configuration, the negative electrode tab terminal 58 is electrically connected to the negative electrode 53.

The positive electrode tab terminal 57 and the negative electrode tab terminal 58 each have a strip shape. The positive electrode tab terminal 57 includes a body portion made of a conductive material and a protective layer made of resin arranged to cover a surface of the body portion. The negative electrode tab terminal 58 similarly includes a body portion made of a conductive material and a protective layer made of resin arranged to cover a surface of the body portion. For the conductive material constituting the body portions, aluminum (Al), nickel (Ni), or other metal can be adopted.

Referring to FIG. 4, the separator 54 is arranged on a top surface of the positive electrode 52 in the stacking direction. The negative electrode 53 is arranged on a top surface of the separator 54. That is, the negative electrode 53 and the positive electrode 52 are arranged in contact with the top surface side and the bottom surface side, respectively of the separator 54. The positive electrode 52, the negative electrode 53, and the separator 54 are each rectangular, for example, in plan view. The positive electrode 52 and the negative electrode 53 have approximately the same shape and same dimensions in plan view. The separator 54 may have larger dimensions than the positive electrode 52 and the negative electrode 53 for the purpose of preventing an internal short circuit. The positive electrode 52 and the negative electrode 53 are almost entirely facing each other, except for misalignments occurring in the course of production or during use.

The dimensions and shape of the positive electrode 52 in plan view (i.e., the dimensions and shape of the main surface of the positive electrode 52) may be, for example, a rectangle with a length of 9.75 mm to 28.5 mm on each side. Preferably, it may be a rectangle with a length of 18.15 mm to 25.5 mm on each side. The area of the positive electrode 52 in plan view (i.e., the area of the main surface of the positive electrode 52) may be, for example, 95 mm² to 812 mm², and preferably 441 mm² to 812 mm².

The dimensions, shape, and area of the negative electrode 53 may be similar to those of the positive electrode 52. The negative electrode 53 may have dimensions slightly greater (in the order of 4% to 7%) than the positive electrode 52. In other words, the dimensions and shape of the negative electrode 53 in plan view (i.e., the dimensions and shape of the main surface of the negative electrode 53) may be, for example, a rectangle with a length of 10.45 mm to 29.2 mm on each side. Preferably, it may be a rectangle with a length of 18.8 mm to 26.15 mm on each side. The area of the negative electrode 53 in plan view (i.e., the area of the main surface of the negative electrode 53) may be, for example, 109 mm² to 852 mm², and preferably 470 mm² to 852 mm².

The area of a region where the positive electrode 52 and the negative electrode 53 are facing each other is set to be an electrode area (S). It should be noted that "facing each other" means, not only the case where the positive electrode 52 and the negative electrode 53 are directly contacting and facing each other, but also the case where the electrodes are facing each other with the separator in between. The electrode area (S) may be, for example, 95 mm² to 812 mm², preferably 329 mm² to 650 mm², and more preferably 600 mm² (6 cm²) or less. It is preferable that the positive electrode 52 and the negative electrode 53 are arranged such that the opposing surfaces are entirely facing each other without misalignments. The electrode area (S) is preferably not less than 90%, and more preferably not less than 96%, of the surface area of the positive electrode 52 and the negative electrode 53.

### (Structure of Positive Electrode)

Referring to FIG. 4, the positive electrode 52 includes the positive electrode current collector 521, a positive electrode active material plate 522, and a conductive bonding layer 523. The positive electrode current collector 521 is a sheet-shaped member having conductivity. The positive electrode current collector 521 has its bottom surface bonded to the resin layer 622 of the exterior body 61 via a positive electrode bonding layer 623. The positive electrode bonding layer 623 is formed of, for example, a resin mixture of acid-modified polyolefin resin and epoxy resin. The positive electrode bonding layer 623 may be formed of another material. The positive electrode bonding layer has a thickness of, for example, 0.5 µm to 10 µm.

The positive electrode current collector 521 includes, for example, a metal foil formed of aluminum or other metal, and a conductive carbon layer laminated on a top surface of the metal foil. In other words, the main surface of the positive electrode current collector 521 facing the positive electrode active material plate 522 is covered with the conductive carbon layer. The metal foil may be formed of a variety of metals other than aluminum (e.g., copper, nickel, silver, gold, chromium, iron, tin, lead, tungsten, molybdenum, titanium, zinc, or an alloy containing any of them). The positive electrode current collector 521 may not include a conductive carbon layer.

The positive electrode active material plate 522 is a thin plate-shaped ceramic sintered body containing a lithium complex oxide. Preferably, the positive electrode active material plate 522 is composed substantially solely of the lithium complex oxide. The separator 54 is laminated on a top surface of the positive electrode active material plate 522. It should be noted that the positive electrode active material plate 522 may be sputtered with gold (Au) or the like as a current collection aid.

The positive electrode active material plate 522 has a structure in which a plurality of (i.e., a large number of) primary particles are bound together. The primary particles are composed of a lithium complex oxide having a layered rock-salt structure. The lithium complex oxide is a complex oxide of lithium and a transition metal element M (general formula: LiₚMO₂ (where 0.05<p<1.10)), partially substituted with another metal element that is a substitution metal element. The transition metal element M includes at least one selected from cobalt (Co), nickel (Ni), and manganese (Mn), for example. The transition metal element M is a main metal other than lithium contained in the above-described lithium complex oxide, and will be hereinafter referred to as "main transition metal element".

Examples of the complex oxide of lithium and transition metal element M include lithium cobaltate (LiₚCoO₂ (where 1≤p≤1.1), lithium nickelate (LiNiO₂), lithium manganate (Li₂MnO₃), lithium nickel manganate (Liₚ(Ni_{0.5},Mn_{0.5})O₂), a solid solution expressed by a general formula: Liₚ(Coₓ,Ni_{y},Mn_{z})O₂ (where 0.97≤p≤1.07, x+y+z=1), a solid solution expressed by Liₚ(Coₓ,Ni_{y},Al_{z})O₂ (where 0.97≤p≤1.07, x+y+z=1, 0<x≤0.25, 0.6≤y≤0.9, and 0<z≤0.1), and a solid solution of Li₂MnO₃ and LiMO₂ (where M represents Co, Ni, or other transition metal). The lithium complex oxide is particularly preferably lithium cobaltate LiₚCoO₂ (where 1≤p≤1.1), which is, for example, LiCoO₂.

The transition metal element M may be, for example, at least one element from magnesium (Mg), aluminum (Al), silicon (Si), calcium (Ca), titanium (Ti), vanadium (V), chromium (Cr), iron (Fe), copper (Cu), zinc (Zn), gallium (Ga), germanium (Ge), strontium (Sr), yttrium (Y), zirconia (Zr), niobium (Nb), molybdenum (Mo), silver (Ag), tin (Sn), antimony (Sb), tellurium (Te), barium (Ba), and bismuth (Bi). Preferably, it is titanium (Ti) or niobium (Nb).

The layered rock-salt structure is a crystal structure in which a lithium layer and a transition metal layer other than lithium are alternately stacked with a layer of oxygen interposed therebetween. In other words, the layered rock-salt structure is a crystal structure in which layers of metal ions other than lithium and layers of lithium alone are alternately stacked via oxide ions. Typically, it is an α-NaFeO₂ type structure, i.e., a structure in which a transition metal and lithium are regularly arranged in the [111] axis direction of the cubic rock-salt type structure.

The conductive bonding layer 523 includes conductive powder and a binder. The conductive powder is powder of, for example, acetylene black, natural flake graphite, carbon nanotube, carbon nanofiber, carbon nanotube derivative, or carbon nanofiber derivative. The binder contains, for example, polyimide amide resin. The binder may contain one type or two or more types of polyimide amide resin. The binder may contain a resin other than polyimide amide resin. The conductive bonding layer 523 may be formed by applying a liquid or paste adhesive containing the above-described conductive powder and binder as well as a solvent to the positive electrode current collector 521 or the positive electrode active material plate 522, and allowing it to solidify by evaporation of the solvent between the positive electrode current collector 521 and the positive electrode active material plate 522.

The positive electrode current collector 521 has a thickness of, for example, 9 µm to 50 µm, preferably 9 µm to 20 µm, and more preferably 9 µm to 15 µm. The positive electrode active material plate 522 has a thickness of, for example, 15 µm to 200 µm, preferably 30 µm to 150 µm, and more preferably 50 µm to 100 µm. The conductive bonding layer 523 has a thickness of, for example, 3 µm to 28 µm, and preferably 5 µm to 25 µm.

### (Structure of Negative Electrode)

Referring to FIG. 4, the negative electrode 53 includes the negative electrode current collector 531 and a negative electrode active material layer 532. The negative electrode current collector 531 is a sheet-shaped member having conductivity. The negative electrode current collector 531 has its top surface bonded to the resin layer 632 of the exterior body 63 via a negative electrode bonding layer 633. The negative electrode active material layer 532 is coated on a bottom surface of the negative electrode current collector 531. That is, the negative electrode 53 is a so-called coated electrode. The negative electrode active material layer 532 faces the separator 54 in the up-down direction.

The negative electrode bonding layer 633 is formed of a resin mixture of acid-modified polyolefin resin and epoxy resin, for example. The negative electrode bonding layer 633 may be formed of various other materials.

The negative electrode current collector 531 is, for example, a metal foil formed of copper or other metal. The metal foil may be formed of various metals other than copper (e.g., copper, stainless steel, nickel, aluminum, silver, gold, chromium, iron, tin, lead, tungsten, molybdenum, titanium, zinc, or an alloy containing any of them).

The negative electrode active material layer 532 includes a binder having resin as its principal component, and a carbonaceous material which is a negative electrode active material. Examples of the carbonaceous material include natural graphite, artificial graphite, pyrolytic carbon, coke, resin fired body, mesophase spherule, and mesophase pitch. In the negative electrode 53, in place of the carbonaceous material, a lithium-occluding material may be used as the negative electrode active material. Examples of the lithium-occluding material include silicon, aluminum, tin, iron, iridium, and alloys, oxides, or fluorides containing any of them. The binder is, for example, styrene-butadiene rubber (SBR), polyvinylidene fluoride (PVDF), or a mixture thereof.

The negative electrode current collector 531 has a thickness of, for example, 5 µm to 25 µm, preferably 8 µm to 20 µm, and more preferably 8 µm to 15 µm. The negative electrode active material layer 532 has a thickness of, for example, 20 µm to 300 µm, preferably 30 µm to 250 µm, and more preferably 30 µm to 150 µm. Making the negative electrode active material layer 532 thicker can increase the active material capacity per unit area, and increase the energy density of the battery 51. Making the negative electrode active material layer 532 thinner can suppress deterioration of battery characteristics (particularly, increase of resistance value) due to repeated charging and discharging.

### (Separator)

The separator 54 is a sheet-shaped or thin plate-shaped insulating member. The separator 54 is, for example, a single layer separator formed of resin. For the resin, for example, polyimide, polyester (e.g., polyethylene terephthalate (PET)), or cellulose can be adopted. The separator 54 has a thickness of, for example, 15 µm or more, preferably 18 µm or more, and more preferably 20 µm or more. The thickness of the separator 54 is, for example, 31 µm or less, preferably 28 µm or less, and more preferably 26 µm or less. By making the separator thicker, even if lithium dendrites (dendritic crystals of lithium) precipitate, a short circuit between the positive and negative electrodes due to the lithium dendrites can be prevented. Further, making the separator thinner facilitates permeation of the electrolytic solution and lithium ions, thereby reducing the internal resistance of the battery 51.

The structure of the separator 54 may be changed to any known structure other than the above. For example, two layers or three or more layers of ceramic and resin may be laminated. Alternatively, it may be a microporous membrane made solely of ceramic. The ceramic is, for example, at least one selected from MgO, Al₂O₃, ZrO, SiC, Si₃N₄, AlN, and cordierite, and preferably at least one selected from MgO, Al₂O₃, and ZrO₂.

### (Electrolytic Solution)

The electrolytic solution 55 is a liquid containing an electrolyte and an additive added to a solvent. The electrolyte is, for example, lithium hexafluorophosphate (LiPF₆). The concentration of LiPF₆ in the electrolytic solution 55 may be, for example, 0.5 to 2.0 mol/L, preferably 0.75 mol/L to 1.5 mol/L, and more preferably 1.0 mol/L to 1.25 mol/L. The electrolyte may be changed, and can be, for example, lithium tetrafluoroborate (LiBF₄).

The solvent of the electrolytic solution 55 is, for example, a non-aqueous solvent such as ethylene carbonate (EC), propylene carbonate (PC), dimethyl carbonate (DMC), diethyl carbonate (DEC), ethyl methyl carbonate (EMC), γ-butyrolactone (GBL), methyl butyrate (MB), propyl acetate (PA), or the like. The solvent may be one containing EC and EMC, for example.

### (Other Batteries)

While the battery 51 is a pouch-type lithium secondary battery containing an electrolytic solution as described above, the battery used in the circuit board assembly of the present disclosure may be a lithium secondary battery of another type. For example, it may be a coin-type lithium secondary battery or an all-solid-state lithium secondary battery. In the case of using an all-solid-state lithium secondary battery, the all-solid-state lithium secondary battery includes an oriented positive electrode plate as the positive electrode, a solid electrolyte member, and a negative electrode plate as the negative electrode.

The oriented positive electrode plate in the all-solid-state lithium secondary battery may be a lithium complex oxide sintered body plate having a voidage of 0% or more and 10% or less. This lithium complex oxide sintered body plate may be a so-called "low-angle oriented positive electrode plate" which includes a plurality of primary particles composed of a lithium complex oxide, the primary particles being oriented at an average orientation angle of greater than 0° and not greater than 30° with respect to the plate face of the oriented positive electrode plate. The solid electrolyte member may contain a solid electrolyte expressed by 3LiOH·Li₂SO₄. The negative electrode plate is a negative electrode plate permitting intercalation and deintercalation of lithium ions at 0.4 V (vs. Li/Li⁺) or more, and may contain Ti.

### (Production Method)

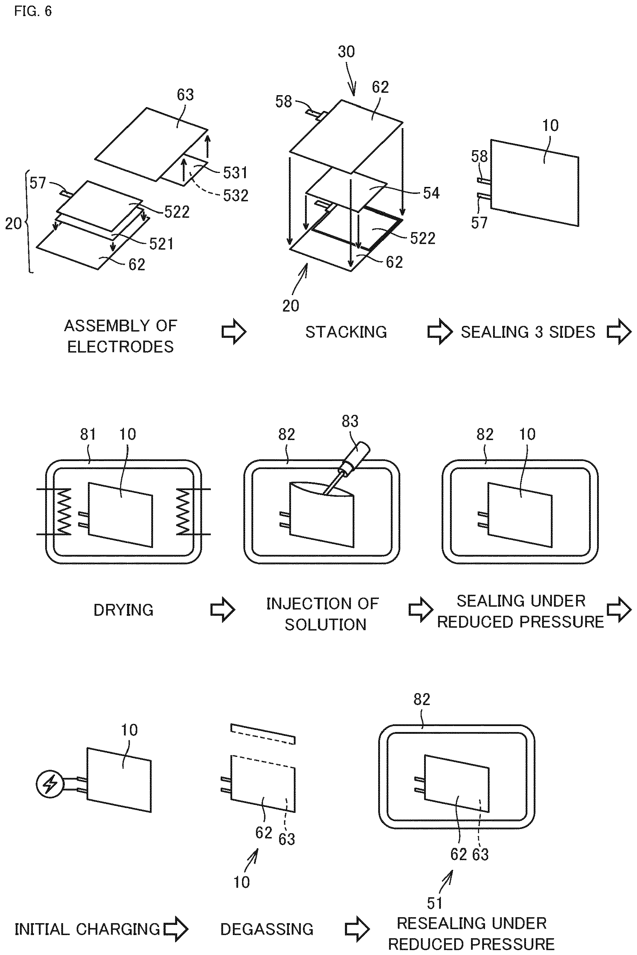

A method of producing a circuit board assembly of the present disclosure will be described. First, examples of the method of producing the battery 51 constituting the circuit board assembly will be described with reference to FIG. 6.

### (Battery Production 1)

Referring to FIG. 6, as exterior films 62 and 63 constituting the exterior body 61, two sheets of aluminum laminated film (produced by Showa Denko Packaging Co. Ltd., thickness: 61 µm, three layer structure of polypropylene film / aluminum foil / nylon film) are prepared.

A positive electrode active material plate 522 is prepared. Of the lithium complex oxide of the positive electrode active material plate 522, the main transition metal element can be Co and the substitution metal element can be Nb. In the example shown in FIG. 6, the positive electrode active material plate 522 is a single plate-shaped member.

The method of producing the positive electrode active material plate 522 will be described.

The positive electrode active material plate 522 is produced, for example, with a so-called green sheet process. First, mixed powder of an oxide of lithium and an oxide of a main transition metal element (e.g., Co) is prepared. Specifically, for example, Co₃Li₄ powder (produced by Seido Chemical Industry Co., Ltd.) and Li₂CO₃ powder (produced by The Honjo Chemical Corporation), weighed to a Li/Co molar ratio of 1.02, are mixed, and the mixed powder is held at 800°C for five hours. The Li/Co molar ratio may be changed as appropriate within a range of 1.00 to 1.05, for example. The holding temperature and holding time of the mixed powder may also be changed as appropriate.

Subsequently, Nb₂O₅ powder (produced by MITSUI MINING & SMELTING CO., LTD.) is added to the above mixed powder, and the mixture is pulverized and disintegrated in a pot mill to achieve a particle size distribution with a volume-based D50 particle size of 0.8 µm, to thereby obtain raw material powder. The particle size distribution can be measured using, for example, Microtrac MT3000II (produced by MicrotracBEL Corp.). The percentage of Nb₂O₅ powder added to the raw material powder is 0.03 mass%. From the atomic weight ratio of the constituent elements of Nb₂O₅, about 70% of the added Nb₂O₅ corresponds to the Nb element. Therefore, the Nb content in the raw material powder is 0.021 mass%. The volume-based D50 particle size of the raw material powder may be changed as appropriate within a range of 0.2 µm to 10 µm, for example. The Nb content in the raw material power may also be changed as appropriate within a range of 0.1 mass% to 2.0 mass%, for example.

Next, 100 parts by weight of the above raw material powder, 32 parts by weight of a dispersion medium (2-ethylhexanol), 8 parts by weight of a binder (product number: BLS, produced by SEKISUI CHEMICAL CO., LTD.), 3.2 parts by weight of a plasticizer (DOP: di phthalate (2-ethylhexy), produced by Kurogane Kasei Co., Ltd.), and 2.5 parts by weight of a dispersant (product number: Marialim SC0505K, produced by NOF CORPORATION) are mixed with a three-roll mill and a planetary centrifugal mixer. The resultant mixture is stirred and defoamed under reduced pressure and adjusted to have a viscosity of 4000 cP to 1000 cP, whereby a slurry is prepared. The compositions and types of the raw materials in the slurry may be changed as appropriate. The viscosity can be measured using an LVT viscometer produced by AMETEK Brookfield, Inc.

To the slurry, a lithium compound other than LiCoOz (for example, lithium carbonate) may be excessively added in an amount of about 0.5 mol% to about 30 mol% for the purposes of promoting grain growth and compensating for volatile matter during a firing step which will be described later. It is desirable that no pore-forming material is added to the slurry.

Then, the slurry is formed into a sheet shape on a polyethylene terephthalate (PET) film by doctor blading, to thereby form a green sheet. The green sheet has a thickness after drying of, for example, about 105 µm. The thickness of the green sheet may be changed as appropriate, for example, within a range with which the thickness after firing of the positive electrode active material plate 522 is 15 µm to 200 µm as described above.

Next, the green sheet stripped off from the PET film is cut into a predetermined size (of 68 mm square, for example) using a cutter, and then placed in the center of a bottom setter (with dimensions of 90 mm square and height of 1 mm, for example). On the green sheet on the bottom setter, a top setter is placed. The top and bottom setters are made of ceramic, preferably zirconia or magnesia. If the setters are made of magnesia, the pores in the positive electrode active material plate 522 tend to be smaller. The top setter may have a porous structure, a honeycomb structure, or a dense structure. If the top setter has a dense structure, the pores in the positive electrode active material plate 522 tend to be smaller, and the number of pores tends to be larger.

The green sheet in the state of being sandwiched between the setters is placed in an alumina sheath of, for example, 120 mm square (produced by NIKKATO CORPORATION). At this time, the alumina sheath is not tightly sealed, and is covered with a lid with a gap of a predetermined size (of 0.5 mm, for example).

The stack of the green sheet and the setters is raised to 900°C at a heating rate of 100°C/h and held for 15 hours for firing. Thereafter, the fired body is cooled to room temperature and then removed from the alumina sheath, whereby the positive electrode active material plate 522 which is the sintered body plate is obtained. The positive electrode active material plate 522 has a thickness of about 100 µm, for example. The sizes of the positive electrode active material plate 522 and the setters may be changed as appropriate. The conditions for firing the positive electrode active material plate 522 may also be changed as appropriate. The firing process may be performed in two steps, or in one step. In the case of firing in two separate steps, the firing temperature in the first step is preferably lower than the firing temperature in the second step. In the case where the positive electrode active material plate 522 has a plurality of active material plate elements, the above-described sintered body plate is cut into a predetermined size with a laser processing machine or the like, to form the plurality of active material plate elements.

The primary particles in the positive electrode active material plate 522 have an average orientation angle of 16°, for example. The average orientation angle can be measured as follows. First, the positive electrode active material plate 522 is polished with a cross section polisher (IB-15000CP, produced by JEOL Ltd.), and the resultant cross section (i.e., a cross section approximately perpendicular to the main surface of the positive electrode active material plate 522) is subjected to measurement by EBSD within a field of view of 125 µm×125 µm at 1000× to obtain an EBSD image. The EBSD measurement is conducted using, for example, a Schottky field emission scanning electron microscope (model: JSM-7800F, produced by JEOL Ltd.). Then, for every particle identified in the resultant EBSD image, an angle formed by the (003) plane of the primary particle and the main surface of the LiCoO₂ sintered body plate (i.e., the inclination of crystal orientation from the (003) plane) is obtained as an inclination angle, and an average value of these angles is set to be the average orientation angle of the primary particles.

The plate thickness of the positive electrode active material plate 522 can be measured by polishing the positive electrode active material plate 522 with a cross section polisher (IB-15000CP, produced by JEOL Ltd.) and observing the resultant cross section described above with an SEM (JSM6390LA, produced by JEOL Ltd.). It should be noted that the above-described thickness of the green sheet after drying can also be measured in the same manner.

The positive electrode active material plate 522 has a porosity of 30%, for example. The porosity can be measured as follows. First, the positive electrode active material plate 522 is polished with a cross section polisher (IB-15000CP, produced by JEOL Ltd.), and the resultant cross section described above is observed with an SEM (JSM6390LA, produced by JEOL Ltd.) within a field of view of 125 µm×125 µm at 1000x. The resultant SEM image is subjected to image analysis, and a total area of all the pores is divided by the area of the positive electrode active material plate 522 and the obtained value is multiplied by 100 to calculate the porosity (%).

The positive electrode active material plate 522 has an average pore diameter of 0.8 µm, for example. The average pore diameter can be measured with a mercury intrusion method using a mercury porosimeter (Autopore IV 9510, produced by SHIMADZU CORPORATION).

In the fabrication of the positive electrode active material plate 522 described above, the green sheet is sandwiched between the top and bottom setters. In this case, the green sheet placed on the bottom setter may be calcined before the top setter is placed on the green sheet. The temperature and time for this calcination are, for example, 600°C to 850°C and 1 hour to 10 hours. In addition, prior to the calcination, the green sheet may be debindered. The top setter is placed on the calcined body formed through calcination.

In the fabrication of the positive electrode active material plate 522 described above, Nb₂O₅ powder is added to the mixed powder of Co₃Li₄ powder and Li₂CO₃ powder and then pulverized to obtain raw material powder. However, the raw material powder may be obtained in another way. For example, first, powder of a complex oxide of lithium and a main transition metal element (i.e., LiCoO₂) is prepared. Specifically, for example, Co₃O₄ powder and Li₂CO₃ powder are mixed, and fired at 500°C to 900°C for 1 hour to 20 hours, to thereby synthesize LiCoO₂ powder. The LiCoO₂ powder preferably contains plate-shaped particles (i.e., plate-shaped LiCoO₂ particles). The LiCoO₂ powder has a volume-based D50 particle size of, for example, 0.3 µm to 30 µm.

The LiCoO₂ powder can be obtained using a variety of techniques of synthesizing plate crystals, which include: a technique in which a green sheet formed using a LiCoO₂ powder slurry is subjected to grain growth and then disintegration, a flux method, hydrothermal synthesis, single crystal growth using a melt, and a sol-gel process. The LiCoO₂ particles obtained with these techniques are in the state of being readily cleaved along cleavage planes, as in the case of the above-described LiCoO₂ particles. It is therefore readily possible to obtain plate-shaped LiCoO₂ particles by cleaving them through disintegration.

Subsequently, the LiCoO₂ powder is added with 0.1 mass% to 2.0 mass% Nb₂O₅ powder, and the resultant powder is pulverized and disintegrated in a pot mill to achieve a particle size distribution with a volume-based D50 particle size of 0.2 µm to 10 µm, thereby obtaining the raw material powder. In the raw material powder, plate-shaped LiCoO₂ particles permitting conduction of lithium ions parallel to the plate faces are obtained through the above-described pulverization and the like. On the surfaces of the LiCoO₂ particles, Nb added prior to the pulverization and the like is attached as NbzOs or in another state.

It should be noted that in the raw material powder, other powder such as Co₃O₄ particles may be mixed in addition to LiCoO₂ powder. In this case, it is preferable that the plate-shaped LiCoO₂ particles function as template particles for imparting orientation, and the other powder (e.g., Co₃O₄ particles) functions as matrix particles capable of growing along the template particles. The mixing ratio between the template particles and the matrix particles is preferably 100:0 to 3:97.

In the case of using Co₃O₄ particles as the matrix particles, the volume-based D50 particle size of the matrix particles, although not particularly limited, is 0.1 µm to 1.0 µm, for example, which is preferably smaller than the volume-based D50 particle size of the template particles. The Co₃O₄ particles can also be obtained by heat-treating a raw material Co(OH)₂ at 500°C to 800°C for 1 hour to 10 hours. Further, as the matrix particles, besides the Co₃O₄ particles, Co(OH)₂ particles may be used, or LiCoO₂ particles may be used.

It should be noted that in the case where LiCoO₂ particles are to be used as the matrix particles, or in the case where only the template particles (LiCoO₂ particles) are to be used without the use of matrix particles, a large-sized (e.g., 90 mm square) and flat LiCoO₂ sintered body plate can be obtained by firing.

After the positive electrode active material plate 522 is prepared, a conductive bonding layer 523 (see FIG. 4) is formed on a positive electrode current collector 521 (e.g., aluminum foil with a thickness of 9 µm). The conductive bonding layer 523 is formed, for example, by dropping, onto the positive electrode current collector 521, 2 µL of a slurry obtained by mixing acetylene black to a solution of polyamide-imide (PAI) dissolved into N-methylpyrrolidone.

Subsequently, the positive electrode active material plate 522 is placed on the conductive bonding layer 523 and dried. The positive electrode active material plate 522 is bonded to the positive electrode current collector 521 via the conductive bonding layer 523. The positive electrode current collector 521 has an end of a positive electrode tab terminal 57 fixed thereto in advance by welding. Thereafter, as illustrated in FIG. 6 ("Assembly of electrodes"), a composite of the positive electrode current collector 521 and the positive electrode active material plate 522 is stacked on the first exterior film 62 and bonded to the exterior film 62 via a positive electrode bonding layer 623 (see FIG. 4). A positive electrode assembly 20 is formed in accordance with the above procedure.

On the other hand, on a negative electrode current collector 531 (copper foil with a thickness of 10 µm, for example), a negative electrode active material layer 532 (with a thickness of 130 µm, for example) which is a carbon layer is coated. The negative electrode active material layer 532 is a carbon coating film that includes a mixture of graphite as an active material and PVDF as a binder. The thickness and material of the negative electrode current collector 531 as well as the thickness and raw material of the negative electrode active material layer 532 may be changed as appropriate.

Subsequently, a composite of the negative electrode current collector 531 and the negative electrode active material layer 532 is stacked on the second exterior film 63 and bonded to the second exterior film 63 via a negative electrode bonding layer 633 (see FIG. 4). The negative electrode current collector 531 has an end of a negative electrode tab terminal 58 fixed thereto in advance by welding. A negative electrode assembly 30 is formed in accordance with the above procedure.

As a separator 54, a polyolefin-based porous membrane (S115, produced by JNC CORPORATION), for example, is prepared. Then, the positive electrode assembly 20, the separator 54, and the negative electrode assembly 30 are laminated in order such that the positive electrode active material plate 522 and the negative electrode active material layer 532 face the separator 54, whereby an intermediate laminate 10 is formed. In the intermediate laminate 10, the laminate of the positive electrode 52, the separator 54, and the negative electrode 53 (hereinafter, also referred to as "battery element") has its top and bottom surfaces covered with the exterior body 61 (exterior films 62 and 63), and the exterior films 62 and 63 extend around the battery element. The battery element has a thickness of 0.33 mm, for example, in the up-down direction thereof. The battery element in plan view has an approximately rectangular shape of 23 mm×32 mm, for example.

The electrode area (S) in the present invention is determined in the above-described laminating process. The electrode area (S) is an area (cm²) of the region where the positive electrode 52 and the negative electrode 53 face each other, or more in detail, an area of the portions of the positive electrode active material plate 522 and the negative electrode active material layer 532 facing each other via the separator 54.

Subsequently, three of the four sides of the approximately rectangular intermediate laminate 10 are sealed by thermal fusion bonding. In the example illustrated in FIG. 6, three sides other than the one on the upper side in the figure are sealed. The three sides include one side on which the positive electrode tab terminal 57 and the negative electrode tab terminal 58 protrude. To seal the three sides, a pressing jig adjusted to have a sealing width of 2 mm, for example, is used, and the outer peripheral portion of the intermediate laminate 10 is heated and pressurized at 200°C and 1.5 MPa for 10 seconds. Accordingly, the exterior films 62 and 63 of the exterior body 61 are thermally fused together. After the sealing of the three sides, the intermediate laminate 10 is placed in a vacuum drier 81 and subjected to moisture removal and drying of the adhesives (i.e., the positive electrode bonding layer 623, the negative electrode bonding layer 633, and the conductive bonding layer 523).

Next, the intermediate laminate 10 is placed in a glove box 82. Then, on the side of the intermediate laminate 10 yet to be sealed, an injection device 83 is inserted between the exterior films 62 and 63, and an electrolytic solution 55 (see FIG. 4) is injected into the intermediate laminate 10 through the injection device 83. The electrolytic solution 55 is a liquid obtained, for example, by dissolving LiPF₆ as the electrolyte in a mixed solvent that contains EC and EMC in a volume ratio of 3:7 so as to have a LiPF₆ concentration of 1 mol/L, and by further adding as an additive. The types of solvent, electrolyte, and additive for the electrolytic solution 55 may be changed in various ways.

After completion of the injection of the electrolytic solution 55, the unsealed side is tentatively sealed with a simple sealer under a reduced atmosphere (e.g., absolute pressure of 5 kPa) in the glove box 82 (i.e., Sealing under reduced pressure). Then, the intermediate laminate 10 is initially charged and aged for a predetermined period (e.g., 7 days). After the aging is completed, the portions of the exterior films 62, 63 that are in the vicinity of the outer edge of the tentatively sealed side are cut off. The cutting is done at the end portions not overlapping with the battery element. Through the cut-off portion, gases including moisture generated during aging are removed ("Degassing" in FIG. 6).

After the degassing is completed, the side formed by the cutting described above is sealed by thermal fusion bonding under a reduced atmosphere (e.g., absolute pressure of 5 kPa) in the glove box 82. For the sealing, as in the above-described sealing of the three sides, a pressing jig adjusted to have a sealing width of 2 mm, for example, is used, and the exterior films 62 and 63 are heated and pressurized at 200°C and 1.5 MPa for 10 seconds. Accordingly, the exterior films 62 and 63 are thermally fused together, whereby a lithium secondary battery 51 is formed. Thereafter, redundant outer peripheral portions of the exterior body 61 are cut off to shape the lithium secondary battery 1. For example, the lithium secondary battery 51 has a rectangular shape in plan view, with dimensions of 38 mm×27 mm, a thickness of 0.45 mm or less, and a capacity of 30 mAh.

### (Battery Production 2)

The substitution metal element in the positive electrode active material plate 522 is not limited to Nb, and may be Ti, for example. An example of the method of producing the positive electrode active material plate 522 in the case where the substitution metal element is Ti will now be described. First, as in the case where the substitution metal element is Nb, mixed powder of an oxide of lithium and an oxide of the main transition metal element (i.e., Co) is prepared and held at 800°C for five hours.

Subsequently, TiO₂ powder (produced by ISHIHARA SANGYO KAISHA, LTD.) is added to the mixed powder, and the mixture is pulverized and disintegrated in a pot mill to achieve a particle size distribution with a volume-based D50 particle size of 0.8 µm, to thereby obtain raw material powder. The particle size distribution can be measured using, for example, Microtrac MT3000II (produced by MicrotracBEL Corp.). The percentage of TiO₂ powder added to the raw material powder is 0.4 mass%. From the atomic weight ratio of the constituent elements of TiO₂, about 60% of the added TiO₂ corresponds to the Ti element. Therefore, the Ti content in the raw material powder is 0.24 mass%. The volume-based D50 particle size of the raw material powder may be changed as appropriate within a range of 0.2 µm to 10 µm, for example. The Ti content in the raw material power may also be changed as appropriate within a range of 0.1 mass% to 2.0 mass%, for example.

Next, the above-described raw material powder, dispersion medium, binder, plasticizer, and dispersant are mixed in the same configuration as in Battery Production Example 1. The resultant mixture is stirred and defoamed under reduce pressure and the viscosity is adjusted, to prepare a slurry. The compositions and types of the raw materials in the slurry may be changed as appropriate. Further, in the slurry, a lithium compound other than LiCoO₂ may be excessively added, as in Battery Production Example 1. It is desirable that no pore-forming material is added to the slurry.

Further, a positive electrode active material plate 522 containing Ti as the substitution metal element is fabricated in the same technique and fabrication conditions as in Battery Production Example 1. Specifically, first, the above slurry is formed into a sheet shape on a PET film by doctor blading, to form a green sheet. Subsequently, the green sheet stripped off from the PET film is cut into a predetermined size using a cutter. The green sheet is then fired to obtain the positive electrode active material plate 522.

The resultant positive electrode active material plate 522 is combined with other members, as in Battery Production Example 1, to obtain a lithium secondary battery 51.

### (Battery Production Example 3)

In the lithium secondary battery 51, the positive electrode 52 does not necessarily have to be a sintered plate electrode having the positive electrode active material plate 522 which is the plate-shaped ceramic sintered body; it may be a coated electrode like the negative electrode 53. In this case, the positive electrode 52 includes the above-described positive electrode current collector 521 and a positive electrode active material layer coated on the positive electrode current collector 521. The positive electrode active material layer includes the above-described lithium complex oxide as the positive electrode active material and a binder with resin as its principal component. The lithium complex oxide is, as stated above, a complex oxide of lithium and a transition metal element (e.g., Co, Ni, Mn), partially substituted with a substitution metal element (e.g., Nb, Ti). The binder is, for example, styrene-butadiene rubber (SBR), polyvinylidene fluoride (PVDF), or a mixture thereof.

An example of the method of producing the positive electrode 2 in the case where the positive electrode 52 is a coated electrode will now be described. In the following description, the case where the main transition metal element and the substitution metal element are Co and Nb, respectively, will be described. First, mixed powder of an oxide of lithium and an oxide of the main transition metal element (i.e., Co) is prepared, as in the case where the positive electrode 52 includes the positive electrode active material plate 522. The mixed powder is held at 900°C for 10 hours.

Subsequently, as in the case where the positive electrode 52 includes the positive electrode active material plate 522, Nb₂O₅ powder (produced by MITSUI MINING & SMELTING CO., LTD.) is added to the mixed powder, and the mixture is pulverized and disintegrated in a pot mill to achieve a particle size distribution with a volume-based D50 particle size of 0.8 µm, to thereby obtain raw material powder. The percentage of NbzOs powder added to the raw material powder is 0.03 mass%, and the Nb content in the raw material powder is 0.021 mass%. The volume-based D50 particle size of the raw material powder may be changed as appropriate within a range of 0.2 µm to 10 µm, for example. The Nb content in the raw material power may also be changed as appropriate within a range of 0.1 mass% to 2.0 mass%, for example.

Next, 91 mass% of the above-described raw material powder, 5 mass% of acetylene black, 4 mass% of polyvinylidene fluoride (PVDF), and a solution of N-methylpyrrolidone (NMP) are mixed together to prepare a slurry. The slurry is then applied onto the positive electrode current collector 521 (e.g., aluminum foil with a thickness of 10 µm) and dried. Thereafter, the dried coating layer is pressed, whereby the positive electrode 52 as the coated electrode is fabricated.

The resultant positive electrode 52 is combined with other members, as in Battery Production Example 1, to obtain a lithium secondary battery 51.

### (Production of Circuit Board Assembly)

The lithium secondary battery 51 and the other components are mounted on the wiring board 21 to obtain a circuit board assembly 1. Specific production process is not particularly limited and it can be produced using a known method and known conditions. For example, the exterior film 62 of the lithium secondary battery 51 is adhered to the board, and then the positive electrode tab terminal 57 and the negative electrode tab terminal 58 of the lithium secondary battery 51 are connected to the wiring of the wiring board 21 via solder. In addition, terminals of the components other than the lithium secondary battery 51, for example the wireless communication device 22, may be connected to the wiring of the wiring board 21 via solder.

### [EXAMPLES]

The circuit board assembly of the present disclosure will be described in more detail using Examples and Comparative Examples.

### [Example 1]

A lithium secondary battery was obtained in accordance with the production method described in Battery Production Example 1. As the conductive material of the positive electrode tab terminal in the lithium secondary battery, aluminum was used. As the conductive material in the negative electrode tab terminal, nickel was used. The resultant lithium secondary battery was mounted on the wiring board, to obtain the circuit board assembly. In the mounting of the lithium secondary battery onto the wiring board, SUNBONDER USM-560 and CERASOLZER.ECO #155 (both produced by Kuroda Techno Co., Ltd.) were used as an ultrasonic soldering device. Soldering was conducted at 250°C.

### (Measurement of Electrode Area (S))

The electrode area (S) is determined on the basis of design. The electrode area can also be determined by performing image recognition at the time of mounting electrodes in the battery production process to check the dimensions of the facing portions of the electrodes. The electrode area was 6.0 cm².

### (Measurement of Battery Resistance (R))

The battery resistance (R) was measured for the circuit board assembly on which the lithium secondary battery and others were mounted. For the measurement, an electrochemical measurement system (model number: VMP-3, produced by BioLogic Science Instruments) was used to measure the internal resistance of the battery using an AC impedance method. The resistance value (Ω) at 10 Hz was read from the resultant Cole-Cole plot. The measurement of the internal resistance was performed with an amplitude of 2 mV and a measurement frequency range of 250 kHz to 200 mHz. The measurement was conducted by pressing an Au-plated probe pin onto a pad portion on the circuit board terminal side. The battery resistance was 0.5 Ω.

### [Examples 2 to 4, Comparative Examples 1 and 2]

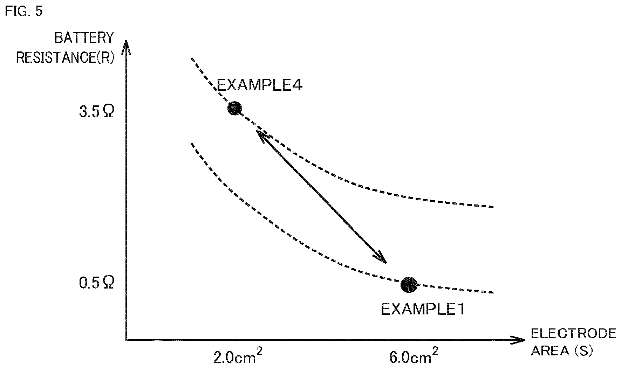

Circuit board assemblies were fabricated as in Example 1, except that the electrode area (S), the battery resistance (R), and the battery resistance per electrode area (R/S) were set as shown in Table 1. FIG. 5 is a graph illustrating a relationship between the electrode area (S) and the battery resistance (R).

**[Table 1]**

| | Battery Resistance | Electrode Area (S) (cm²) | R/S |
|---|---|---|---|
| | (R) (Ω) | | (Ω/cm²) |
| Example 1 | 0.5 | 6.0 | 0.08 |
| Example 2 | 2.2 | 5.5 | 0.4 |
| Example 3 | 2.1 | 4.3 | 0.5 |
| Example 4 | 3.5 | 2.0 | 1.75 |
| Comparative Example 1 | 0.3 | 6.0 | 0.05 |
| Comparative Example 2 | 3.5 | 1.8 | 2.00 |

For the circuit board assemblies in Examples 1 to 4 and Comparative Examples 1 and 2, pulse output performance and cycle characteristics were evaluated in accordance with the following methods.

### (Evaluation of Pulse Output Performance)

The measurement was conducted using a charge-discharge system (model number: SP-150, produced by BioLogic Science Instruments) by connecting it to the positive electrode tab terminal and the negative electrode tab terminal of the lithium secondary battery used in each of Examples 1 to 4 and Comparative Examples 1 and 2. A pulse output with a current of 140 mA for 1s followed by a 1s rest was repeated 10 times. The amount of voltage drop (iR drop) in all the pulse waveforms at this time was measured.

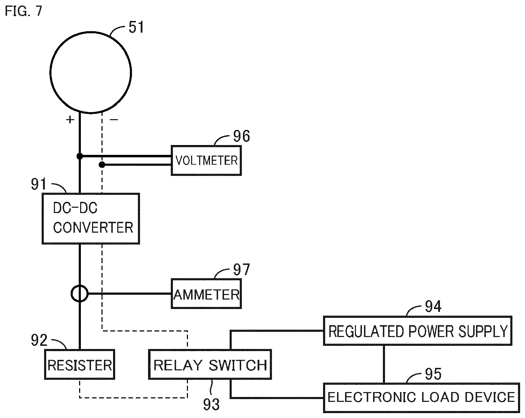

As a circuit for evaluation of the lithium secondary battery (hereinafter, referred to as "evaluation circuit"), the circuit of FIG. 7 may be configured for use in evaluation. Referring to FIG. 7, in the evaluation circuit, a 3.3V constant-voltage output of a DC-DC converter 91 is connected to a resistor 92 that is set to 220 Ω (AR500L25, produced by Beckman Coulter, Inc.) and a relay switch 93 (G2R-1-SN DC24, produced by OMRON Corporation). The input side of the relay switch 93 is connected to a regulated power supply 94 (PMX500-0.1A, produced by KIKUSUI ELECTRONICS CORPORATION) and an electronic load device 95 (PLZ-30F, produced by the same).

In order to monitor the output of the lithium secondary battery, the input side of the DC-DC converter 91 is connected to a voltmeter 96 (MR8870, produced by HIOKI E.E. CORPORATION), and in order to check the output current of the DC-DC converter 91, the output side of the DC-DC converter 91 is connected to an ammeter 97 (CT6700, produced by the same).

In the above evaluation circuit, as the output from the DC-DC converter 91, the pulse output with a current of 140 mA for 1s followed by a 1s rest is repeated 10 times. The amount of voltage drop (iR drop) in all the pulse waveforms at this time is measured.

In the above measurement, the pulse output was determined to be good (o) when the voltage drop amount (iR drop) was not greater than 0.5 V for all the pulse waveforms. The pulse output was determined to be insufficient (×) when the voltage drop amount (iR drop) exceeded 0.5 V

### (Evaluation of Cycle Characteristics)

A charge-discharge test with repeated constant current-constant voltage charging (CCCV charging) and constant current discharging (CC discharging) was conducted using a charge-discharge system (model number: SP-150, produced by BioLogic Science Instruments, or model number: TOSCAT-3100, produced by TOYO SYSTEM CO., LTD.) by connecting it to the positive electrode tab terminal and the negative electrode tab terminal of the lithium secondary battery used in each of Examples 1 to 4 and Comparative Examples 1 and 2. For the charging, constant current charging with a current amount of 0.5 C was performed until a predetermined voltage was reached. The terminating condition was set to cut off at 0.05 C. For the discharging, constant current discharging at 0.5 C was performed, and the terminating condition was set to a predetermined voltage. The charge-discharge cycle was repeated 300 times.

The discharge capacity after 300 charge-discharge cycles was divided by the initial discharge capacity to obtain a capacity retention rate (%). The cycle characteristics were determined to be good (o) when the capacity retention rate was 90% or higher. The cycle characteristics were determined to be insufficient (×) when the capacity retention rate was less than 90%.

Table 2 shows the results of pulse output performance evaluation and cycle characteristics evaluation.

**[Table 2]**

| | R/S (Ω/cm²) | Pulse Output Performance | Cycle Characteristics | Capacity Retention Rate (%) |
|---|---|---|---|---|
| Example 1 | 0.08 | ○ | ○ | 92 |
| Example 2 | 0.4 | ○ | ○ | 94 |
| Example 3 | 0.5 | ○ | ○ | 96 |
| Example 4 | 1.75 | ○ | ○ | 97 |
| Comparative Example 1 | 0.05 | ○ | × | 82 |
| Comparative Example 2 | 2.00 | × | ○ | 95 |

As shown in Table 2, in Examples 1 to 4, circuit board assemblies with good pulse output performance and excellent cycle characteristics were obtained. On the other hand, in Comparative Example 1 with R/S of less than 0.08, although the pulse output performance was good because of the low battery resistance, the capacity retention rate was insufficient, resulting in poor durability. In Comparative Example 2 with R/S exceeding 1.80, although the capacity retention rate was good, the high resistance resulted in insufficient pulse output performance. With R/S of 0.08 or more and 1.80 or less, circuit board assemblies high in pulse output performance and also excellent in durability (reliability) were obtained.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### Reference Signs List

1: circuit board assembly; 11, 12, 13: wiring; 10: intermediate laminate; 20: positive electrode assembly; 30: negative electrode assembly; 21: wiring board; 22: wireless communication device; 23: electronic component; 25: antenna; 51: battery; 52: positive electrode; 521: positive electrode current collector; 522: positive electrode active material plate; 523: conductive bonding layer; 53: negative electrode; 531: negative electrode current collector; 532: negative electrode active material layer; 54: separator; 55: electrolytic solution; 57: positive electrode tab terminal; 58: negative electrode tab terminal; 61: exterior body; 62, 63: exterior film; 621, 631: metal foil; 622, 632: resin layer; 623: positive electrode bonding layer; 633: negative electrode bonding layer; 81: vacuum drier; 82: glove box; 83: injection device; 91: DC converter; 92: resistor: 93: relay switch; 94: regulated power supply; 95: electronic load device; 96: voltmeter; and 97: ammeter.

## Claims

1. A circuit board assembly comprising: a wiring board; a lithium secondary battery electrically connected to the wiring board; and a wireless communication device electrically connected to the wiring board;
the lithium secondary battery including a positive electrode, a negative electrode arranged to face the positive electrode, and an electrolyte,
in the lithium secondary battery, an electrode area (S) and a battery resistance (R) satisfying a relationship of 0.08 ≤ R/S (Ω/cm²) ≤ 1.80, the electrode area being an area where the positive electrode and the negative electrode face each other.

2. The circuit board assembly according to claim 1, wherein the electrode area (S) is 6 cm² or less.

3. The circuit board assembly according to claim 1 or 2, wherein the lithium secondary battery further includes a separator disposed between the positive electrode and the negative electrode, and includes, as the electrolyte, an electrolytic solution impregnated into the positive electrode, the negative electrode, and the separator.

4. The circuit board assembly according to any one of claims 1 to 3, wherein the positive electrode includes a plate-shaped ceramic sintered body containing a lithium complex oxide, the lithium complex oxide being a complex oxide of lithium and a transition metal element, partially substituted with another metal element that is a substitution metal element.
